# EUROPÄISCHE PATENTSCHRIFT

(11) **EP 3 995 443 B1**
(45) Veröffentlichungstag und Bekanntmachung des Hinweises auf die Patenterteilung: **23.04.2025**
(21) Anmeldenummer: 21206512.2
(22) Anmeldetag: 04.11.2021
(51) Int. Cl.: B81C 1/00

(54) **VERFAHREN ZUR HERSTELLUNG EINES ELEKTRONISCHEN BAUELEMENTS**
METHOD FOR MANUFACTURING AN ELECTRONIC ELEMENT
PROCÉDÉ DE FABRICATION D'UN COMPOSANT ÉLECTRONIQUE

(30) Priorität: 05.11.2020 DE 102020129205
(43) Veröffentlichungstag der Anmeldung: 11.05.2022
(73) Patentinhaber: Fraunhofer-Gesellschaft zur Förderung der angewandten Forschung e.V., 80686 München (DE)
(72) Erfinder: OPPERMANN, Hans-Hermann, 13355 Berlin (DE); MANIER, Charles-Alix, 13355 Berlin (DE); FRÖHLICH, Juliane, 13355 Berlin (DE)
(74) Vertreter: Pfenning, Meinig & Partner mbB

(56) Entgegenhaltungen:
- US-A1- 2008 231 145
- WEI-SHAN WANG ET AL: "Substrate bonding at low temperature by using plasma activated porous gold", 2013 IEEE SENSORS, IEEE, 28 October 2012 (2012-10-28), pages 1 - 4, XP032308616, ISSN: 1930-0395, DOI: 10.1109/ICSENS.2012.6411157

## Beschreibung

Die vorliegende Anmeldung betrifft ein Verfahren zur Herstellung eines elektronischen Bauelements und ein elektronisches Bauelement.

Bei der Herstellung elektronischer Bauelemente kann es vorgesehen sein, dass eine Komponente mit einer Kappe oder einem Deckel hermetisch verkapselt wird. Zwischen der Komponente und der Kappe ist anschließend ein abgedichteter Zwischenraum vorgesehen, der luftentleert unter Unterdruck beziehungsweise Vakuum, steht oder der gezielt mit einem Gas befüllt ist. Bei der Herstellung eines solchen elektronischen Bauelements kann es beispielsweise vorgesehen sein, dass die Kappe in einem Lötprozess in einer Bondkammer, in der das gewünschte Vakuum oder eine gezielte Gasatmosphäre herrscht, in einem einstufigen Prozess verschlossen wird. Es kann auch ein zweistufiger Prozess vorgesehen sein, bei dem die Kappe in einem Lötprozess bis auf eine kleine, freigelassene Öffnung verschlossen und der Zwischenraum zwischen Kappe und Komponente anschließend in einer Kammer unter Vakuum oder Gas gesetzt und dann verschlossen wird. Das Verschließen erfolgt beispielsweise mittels Laserlöten eines Lotdepots an der Öffnung, durch Schmelzen des Lotdepots an der Öffnung mit lokalen Heizstrukturen oder durch Sputtern oder Aufdampfen von Material zum Verschließen der Öffnung. Es kann insbesondere bei Metallkappen vorgesehen sein, dass ein Röhrchen angeschweißt wird. Durch Anschließen einer Vakuumpumpe an das Röhrchen kann dann ein Vakuum im Zwischenraum erzeugt werden und anschließend kann das Röhrchen mit einer Zange verschlossen und verkürzt werden. Die Druckschrift US 2008/231145 A1 betrifft eine Quarzkristallvorrichtung, die ein Kristallresonatorelement und ein Gehäuse enthält. Mehrere Komponenten werden unter Verwendung eines Metallpasten-Dichtungsmaterials verbunden, das Metallpartikel, ein organisches Lösungsmittel und ein Harzmaterial enthält. Weiterer Stand der Technik ist dem Dokument "WEI-SHAN WANG ET AL: Substrate bonding at low temperature by using plasma activated porous gold, 2013 IEEE SENSORS, IEEE" zu entnehmen.

Vor dem Hintergrund dieser Aspekte ist es eine Aufgabe der vorliegenden Anmeldung ein verbessertes Verfahren zur Herstellung eines elektronischen Bauelements vorzuschlagen. Insbesondere ist es eine Aufgabe der vorliegenden Anmeldung ein Verfahren vorzuschlagen, das die Herstellung eines elektronischen Bauelements mit zuverlässig abgedichtetem Zwischenraum in vergleichsweise einfacher und kostengünstiger Weise ermöglicht. Außerdem ist es eine Aufgabe der vorliegenden Anmeldung ein entsprechend vorteilhaftes elektronisches Bauelement vorzuschlagen.

Gelöst werden diese Aufgaben durch ein erfindungsgemäßes Verfahren, das in Anspruch 1 definiert ist.

Vorteilhafte Weiterbildungen ergeben sich mit den Merkmalen der abhängigen Ansprüche und der Ausführungsbeispiele.

Bei dem vorgeschlagenen Verfahren zur Herstellung eines elektronischen Bauelements werden eine flächige Komponente und eine, insbesondere flächige, Kappe bereitgestellt. Außerdem wird ein poröses und fluiddurchlässiges, insbesondere gasdurchlässiges, Dichtelement auf der Kappe oder auf der Komponente angeordnet. Ferner werden die Komponente und die Kappe so zueinander angeordnet, dass das Dichtelement zwischen der Kappe und der Komponente angeordnet ist und sowohl mit der Kappe als auch der Komponente in Kontakt steht und dass ein Zwischenraum zwischen der Kappe und der Komponente zumindest abschnittsweise durch das poröse und fluiddurchlässige Dichtelement begrenzt wird. Der Zwischenraum wird in der Regel, beispielsweise vollständig, durch das Dichtelement, die Komponente und die Kappe begrenzt. In einem weiteren Schritt erfolgt ein erstes Bonden der Komponente und der Kappe durch Anwenden eines ersten Bonddrucks und/oder einer ersten Bondtemperatur derart, dass eine mechanisch haltbare Verbindung zwischen der Komponente und der Kappe erzeugt wird. In einem weiteren Schritt, beispielsweise nach dem ersten Bonden, werden die Kappe und die Komponente einem Fluid, insbesondere einer Gasatmosphäre, oder einem Vakuum ausgesetzt, wobei Fluid, insbesondere Gas, durch Poren des Dichtelements in den Zwischenraum strömt oder aus diesem entweicht. Währenddessen oder anschließend erfolgt ein zweites Bonden der Komponente und der Kappe durch Anwenden eines zweiten Bonddrucks und/oder einer zweiten Bondtemperatur, wodurch die Poren des Dichtelements verschlossen werden und der Zwischenraum abgedichtet wird. In der Regel erfolgt das zweite Bonden in der Gasatmosphäre oder in dem Vakuum, insbesondere in einer dafür vorgesehenen Kammer. Nach dem zweiten Bonden ist somit typischerweise das Fluid, insbesondere das Gas, das durch die Poren des Dichtelements in den Zwischenraum geströmt ist, oder ein Vakuum, das durch Entweichen von Fluid, insbesondere Gas, durch die Poren des Dichtelements erzeugt wurde, im abgedichteten Zwischenraum aufgenommen. Unter einem Vakuum im Sinne der vorliegenden Anmeldung ist typischerweise Druck von weniger als 300 mbar oder in einigen Ausführungen auch ein Unterdruck von 300 mbar oder mehr zu verstehen.

Das vorgeschlagene Verfahren erlaubt es, ein elektronisches Bauelement, das einen zuverlässig abgedichteten Zwischenraum aufweist, vergleichsweise einfach und günstig herzustellen. Dies wird insbesondere dadurch erreicht, dass das erste Bonden, bei dem beispielsweise ein Alignment stattfindet, nicht notwendigerweise in dem Fluid bzw. der Gasatmosphäre bzw. in dem Vakuum stattfinden muss. Beispielsweise kann das erste Bonden in einem ersten Bonder durchgeführt werden. Es kann auch vorgesehen sein, dass das Anordnen der Komponente und der Kappe zu einander durch den ersten Bonder erfolgt. Mit dem Anordnen und dem ersten Bonden erfolgt in der Regel die Positionierung und Fixierung der Kappe, was beispielsweise an Luft erfolgen kann. Es ist in typischen Ausführungen vorgesehen, dass das Dichtelement zur mechanischen Haltbarkeit der durch das erste Bonden erzeugten Verbindung zwischen Kappe und Komponente beiträgt, insbesondere alleinig oder gemeinsam mit weiteren Komponenten. Das Dichtelement stellt in typischen Ausführungen sowohl die mechanisch haltbare Verbindung zwischen der Komponente und der Kappe sicher und gewährleistet die Abdichtung des Zwischenraums. Für den ersten Bonder kann somit eine große Auswahl auf den Zweck angepasster und herkömmlicher Bonder zur Verfügung stehen, die vorteilhafterweise ein zuverlässiges Alignment ermöglichen. Das erste Bonden kann somit eine genaue Platzierung und Fixierung der Kappen erlauben, ohne dass der Zwischenraum in diesem Schritt bereits abgedichtet werden muss. Dies ist besonders vorteilhaft, da viele präzise Chip-Bonder für eine sequentielle Bestückung kein Vakuum oder Prozessgas haben. Ein Pumpen des Vakuums oder ein Befüllen mit einem Gas kann vor einem Abdichten des Dichtelements in einem zweiten Prozessschritt erfolgen. Das zweite Bonden kann somit in einem zweiten Bonder erfolgen, der zur Erzeugung der Gasatmosphäre bzw. des Vakuums eingerichtet ist. Hierbei wird in der Regel kein Setzen der Kappe mehr benötigt, was den zweiten Bonder bzw. eine Bondkammer des zweiten Bonders wesentlich vereinfacht. Es kann damit vorgesehen sein, dass der erste Bonder nicht mit einem Vakuum- und/oder Gasanschluss ausgestattet ist und/oder dass der zweite Bonder nicht mit einer Vorrichtung zum Setzen einer Kappe ausgestattet ist. Bei dem vorgeschlagenen Verfahren ist es daher nicht notwendig, dass der erste Bonder oder eine Bauteilzuführung des ersten Bonders wie bei bekannten Verfahren in eine hermetische Kammer gesetzt werden oder dass eine kleine Glocke vorgesehen ist, die über die Bondstelle abgesenkt wird, sodass durch das vorgeschlagene Verfahren lange Prozesszeiten und hohen Kosten vermieden werden können.

Entsprechend vorteilhaft ist ein elektronisches Bauelement, das insbesondere die flächige Komponente, die flächige Kappe und das Dichtelement, das zwischen der Kappe und der Komponente angeordnet ist und sowohl mit der Kappe als auch der Komponente in Kontakt steht, umfasst. Der Zwischenraum zwischen der Kappe und der Komponente kann zumindest abschnittsweise durch das Dichtelement begrenzt werden. Das Dichtelement kann so verdichtet sein, dass die Poren des Dichtelements verschlossen und der Zwischenraum abgedichtet ist. In dem Zwischenraum herrscht in der Regel eine Edelgas- oder Inertgasatmosphäre oder ein Vakuum. Insbesondere kann die vorliegende Anmeldung ein durch ein wie unten oder oben beschriebenes Verfahren hergestelltes elektronisches Bauelement betreffen. Für einen Fachmann ist anhand des fertig hergestellten elektronischen Bauelements erkennbar, dass dieses durch den wie oben oder unten beschriebenen Herstellungsprozess gefertigt wurde. Das Dichtelement weist hierbei in der Regel weiterhin eine in gewissem Maße poröse Struktur auf, die durch das zweite Bonden geschlossene Poren enthält, wobei das Dichtelement in der Regel keine komplette Verdichtung aufweist. Daher wird der Fachmann im Querschnitt des Dichtelements typischerweise regelmäßige Poren erkennen.

Es kann vorgesehen sein, dass das poröse und fluiddurchlässige Dichtelement ein poröses Metall, insbesondere poröses Gold, enthält. Es kann außerdem vorgesehen sein, dass das poröse und fluiddurchlässige Dichtelement nanoporös ist. Typischerweise ist das poröse Material des Dichtelements aus der Gruppe der Edel-Metalle. In der Regel ist das Dichtelement offenporig. Es kann vorgesehen sein, dass das Dichtelement überwiegend aus Gold ist. In diesem Fall ist das Dichtelement besonders geeignet vor dem zweiten Bonden Fluid bzw. Gas durch Poren des Dichtelements in den Zwischenraum strömen oder aus diesem entweichen zu lassen und andererseits durch geeignete Prozessparameter beim zweiten Bonden den Zwischenraum eine zuverlässige Abdichtung zu gewährleisten. In typischen Ausführungen wird der Zwischenraum vor dem Abdichten des Zwischenraums über das Dichtelement mit einem Gas befüllt. Nach dem Abdichten kann das Dichtelement den Zwischenraum abdichten, wobei ein Gas in dem Zwischenraum ein inertes Gas, beispielsweise Stickstoff, oder ein Edelgas wie Helium, Argon oder Krypton sein kann.

Typischerweise ist das Dichtelement ringförmig. In diesem Fall kann von einem Dichtring gesprochen werden. Es kann vorgesehen sein, dass das Dichtelement den Zwischenraum zwischen der Kappe und der Komponente ringartig umgibt. Das Dichtelement kann, insbesondere zur besonders zuverlässigen Abdichtung des Zwischenraums, den Zwischenraum in typischen Ausführungen vollständig geschlossen umlaufen, insbesondere im Sinne eines geschlossenen Rings. Das Dichtelement kann, muss aber nicht notwendigerweise kreisrund sein. Eine Porosität des Dichtelements (definiert als 1 minus dem Quotienten aus Rohdichte und Reindichte) beträgt vor dem zweiten Bonden in der Regel zumindest 0,2, insbesondere zumindest 0,4, oder zumindest 0,65 und/oder höchstens 0,9. Eine zuverlässige Abdichtung nach dem zweiten Bonden kann in der Regel bereits mit einer Porosität größer 0,65 bis 0,9 erreicht werden. Dabei geht die Porosität typischerweise von einer offenporigen Struktur in eine geschlossene Porenstruktur beziehungsweise in eine Struktur mit eingeschlossenen Poren über. Dieser Vorgang kann durch temperatur- und zeitabhängige Diffusionsvorgänge während der Verdichtung unterstützt werden. Um eine zuverlässige Abdichtung des Zwischenraums bei geringem Platzbedarf für das Dichtelement zu ermöglichen beträgt eine Breite des Dichtelements an seiner schmalsten Stelle in der Regel zumindest 1 µm und/oder höchstens 500 µm. Eine Höhe des Dichtelements beträgt nach dem zweiten Bonden in der Regel zumindest 1 µm und/oder höchstens 40 µm. Vor seinem Verdichten durch das zweite Bonden kann eine Höhe des Dichtelements beispielsweise um zumindest 1 µm und/oder höchstens 30 µm größer sein. Weiterhin kann das Dichtelement in einigen Ausführungen auf einem, insbesondere rahmenförmigen und/oder stoffschlüssigen, Unterbau bzw. Abstandshalter bzw. Rahmen gebildet sein, wodurch eine Erhöhung eines Zwischenraum-Volumens erreicht werden kann.

Es kann vorgesehen sein, dass das Dichtelement auf der Kappe und/oder auf der Komponente durch Abscheiden, insbesondere galvanisches Abscheiden, auf der Kappe bzw. Komponente angeordnet wird. Bevorzugterweise wird das poröse und fluiddurchlässige Dichtelement durch Anordnen, insbesondere Abscheiden, einer Legierung auf der Kappe oder auf der Komponente hergestellt. Die Legierung kann eine erste Legierungskomponente, insbesondere eine metallische, und eine zweite Legierungskomponente, insbesondere eine metallische, enthalten. In der Regel ist die erste Legierungskomponente edler und die zweite Legierungskomponente weniger edel. Es kann vorgesehen sein, dass die erste Legierungskomponente Gold ist. Es kann beispielsweise vorgesehen sein, dass die zweite Legierungskomponente Silber ist. In einem weiteren, insbesondere einem nachfolgenden, Schritt kann die zweite Legierungskomponente geätzt werden, insbesondere derart, dass die erste Legierungskomponente verbleibt und dadurch das poröse und fluiddurchlässige Dichtelement ausbildet. Auf diese Weise kann ein besonders homogener Dichtungsring erzeugt werden, der sich durch eine vorteilhafte Strukturierbarkeit bei kleinen Abmessungen auszeichnet.

Es kann vorgesehen sein, dass die Kappe oder die Komponente eine Gegenfläche aufweist. Die Gegenfläche kann vor dem ersten Bonden auf der Komponente oder auf der Kappe so dem Dichtelement gegenüber angeordnet und ausgebildet sein, dass durch das erste Bonden eine stoffschlüssige Verbindung zwischen dem Dichtelement und der Gegenfläche ausgebildet wird. Die Gegenfläche kann beispielsweise eine Metallschicht umfassen. Die Gegenfläche kann beispielsweise das gleiche Material enthalten wie das Dichtelement, insbesondere Gold. Auf diese Weise kann erreicht werden, dass eine durch das erste Bonden erzeugte Verbindung zwischen der Kappe und der Komponente mechanisch haltbarer gemacht wird.

Das Dichtelement kann auf einer flachen Fläche der Komponente oder auf einem, beispielsweise stoffschlüssigen und/oder rahmenförmigen, Unterbau angeordnet sein, beispielweise auf einem Metallrahmen oder einem Silizium-Rahmen. Der Unterbau kann beispielsweise vor der Herstellung des Dichtelementes hergestellt werden.

Das erste Bonden und/oder das zweite Bonden können durch Thermokompressionsbonden durchgeführt werden. Zu den Prozessparametern sind normalerweise keine Vorgaben zu machen, solange die beschriebenen funktionalen Resultate des ersten Bondens, d.h. Herstellen einer mechanisch haltbaren Verbindung, und des zweiten Bondens, Abdichten des Zwischenraums, erreicht werden. Vorteilhaft ist es aber in der Regel, wenn der erste Bonddruck und/oder die erste Bondtemperatur niedriger ist als der zweite Bonddruck bzw. die zweite Bondtemperatur. Auf diese Weise kann zuverlässig gewährleistet werden, dass die Verbindung zwischen Kappe und Komponente durch das erste Bonden zwar mechanisch haltbar gemacht, die Poren des Dichtelements jedoch noch nicht fluiddicht verschlossen werden.

In einigen Ausführungen ist es vorgesehen, dass der Zwischenraum beziehungsweise die Kappe und die Komponente ausgeheizt werden, insbesondere nach dem ersten Bonden und/oder vor dem Abdichten des Zwischenraums. Zu diesem Zweck können, insbesondere im zweiten Bonder oder in einer Kammer des zweiten Bonders, Temperaturprofile gefahren werden. Hierdurch können an Wänden der Kappe oder der Komponente absorbierte Gase entfernt werden, sodass eine größere Reinheit des elektronischen Bauelements erreicht wird. Insbesondere kann ein erreichbares Endvakuum auf diese Weise gesteigert werden.

In einigen Ausführungen ist die Komponente ein Wafer oder ein Waferteil, der insbesondere integrierte Schaltkreise aufweisen kann. Die Kappe kann ein Wafer oder ein Chip sein. Manchmal ist von einem flächigen Element oder Deckel die Rede, womit in der Regel ein flaches Substrat mit einem Dichtelement gemeint ist. Unter einer Kappe ist in der Regel eine weit geläufigere Ausführung zu verstehen, bei dem beispielsweise in das Substrat eine Kavität geätzt wurde und ein Dichtelement auf dem nicht geätzten Teil die Kavität umläuft. Eine weitere Kappenvariante umfasst zwei Teile: ein flaches Substrat und einen fest verbundenen Rahmen, die ebenfalls eine Kavität ausbilden und das Dichtelement auf dem Rahmen verläuft. Jede dieser drei genannten Varianten kann eine Kappe im Sinne der vorliegenden Anmeldung darstellen.

Die Komponente kann ein erstes Substrat und die Kappe ein zweites Substrat bilden. Es kann vorgesehen sein, dass das erste Bonden durch einen Flip-Chip-Bonder erfolgt. Es kann auch vorgesehen sein, dass das Anordnen der Komponente und der Kappe zueinander durch den Flip-Chip-Bonder erfolgt. Hierbei handelt es sich um einen etablierten Prozess, wodurch ein gewünschtes Alignment und die mechanische Verbindung in zuverlässiger Weise erreicht werden. Zudem kann mit einem Flip-Chip-Bonder beim ersten Bonden insbesondere das unten näher beschriebene sequentielle Bonden weiterer Kappen besonders zeitsparend erfolgen. Es kann vorgesehen sein, dass das Anordnen und/oder das erste Bonden durch den Flip-Chip-Bonder an Luft durchgeführt werden.

In einigen Ausführungen wird eine weitere Kappe auf die Komponente gebondet, insbesondere nach dem ersten Bonden der Komponente und der Kappe. Hierbei kann ein weiteres poröses und fluiddurchlässiges, insbesondere gasdurchlässiges, Dichtelement einen weiteren Zwischenraum, der zwischen der weiteren Kappe und der Komponente ausgebildet ist, begrenzen. Das erste Bonden kann sequenziell erfolgen, sodass zumindest fünf, insbesondere zumindest zehn weitere Kappen auf die Komponente gebondet werden. Ein besonderes zeitsparendes Verfahren kann dadurch erreicht werden, dass beim zweiten Bonden gleichzeitig mit der Kappe auch die weitere Kappe, insbesondere die gegebenenfalls vorgesehenen weiteren Kappen, mit der Komponente gebondet wird bzw. werden, wodurch Poren des weiteren Dichtelementes verschlossen und der weitere Zwischenraum (bzw. die weiteren Zwischenräume) abgedichtet wird. Dadurch wird der Verfahrensschritt, bei dem ein Fluid oder eine Gasatmosphäre bzw. ein Vakuum vorgesehen ist, vereinfacht. Eventuelle Höhendifferenzen zwischen den Kappen können beim zweiten Bonden mit einer weichen, insbesondere temperaturbeständigen, Folie ausgeglichen werden. Dadurch kann der Druck auf alle Kappen gleichmäßig verteilt werden. Die Folie kann während des zweiten Bondens auf einer Oberseite der Kappen angeordnet sein.

Es kann auch vorgesehen sein, dass ein zweites poröses und fluiddurchlässiges, insbesondere gasdurchlässiges, Dichtelement auf einer zweiten Kappe oder auf einer zweiten Komponente angeordnet wird. Die zweite Komponente und die zweite Kappe können so zueinander angeordnet werden, dass das zweite Dichtelement zwischen der zweiten Kappe und der zweiten Komponente angeordnet ist und sowohl mit der zweiten Kappe als auch der zweiten Komponente in Kontakt steht und dass ein zweiter Zwischenraum zwischen der zweiten Kappe und der zweiten Komponente zumindest abschnittsweise durch das zweite poröse und fluiddurchlässige Dichtelement begrenzt wird. In einem weiteren Schritt können die zweite Komponente und die zweite Kappe durch Anwenden eines Bonddrucks und/oder einer Bondtemperatur derart gebondet werden, dass eine mechanisch haltbare Verbindung zwischen der zweiten Komponente und der zweiten Kappe erzeugt wird. In einem weiteren Schritt können die zweite Kappe und die zweite Komponente dem Fluid, insbesondere der Gasatmosphäre, oder dem Vakuum gemeinsam mit der Kappe und der Komponente derart ausgesetzt werden, dass Fluid, insbesondere Gas, durch Poren des zweiten Dichtelements in den zweiten Zwischenraum strömt oder aus diesem entweicht und derart, dass die zweite Kappe und die zweite Komponente auf der Kappe und der Komponente angeordnet sind. Beim zweiten Bonden der Komponente und der Kappe kann gleichzeitig die darüber liegende zweite Komponente und zweite Kappe durch Anwenden des zweiten Bonddrucks und/oder der zweiten Bondtemperatur gebondet werden. Hierdurch können die Poren des zweiten Metallelements verschlossen werden und der zweite Zwischenraum abgedichtet werden. Es kann vorgesehen sein, dass die Kappe und die Komponente beim zweiten Bonden von der zweiten Kappe und der zweiten Komponente durch eine Folie getrennt sind. Hierdurch kann eine Beschädigung vermieden und eine gleichmäßige Druckverteilung beim zweiten Bonden erreicht werden. Durch das Anordnen der zweiten Kappe und zweiten Komponente auf der Kappe und Komponente sowie das gleichzeitige zweite Bonden kann die Herstellung besonders einfach und zeitsparend erfolgen. Insbesondere kann des zweite Bonden der zweiten Kappe und zweiten Komponente in dem zweiten Bonder gemeinsam mit der Kappe und Komponente erfolgen, beispielsweise in einem Stapel.

Es kann vorgesehen sein, dass das elektronische Bauelement ein optoelektronisches Bauelement ist. Beispielsweise kann die Komponente und/oder die Kappe eine Laserdiode und/oder einen Photodetektor enthalten. Es kann in einigen Ausführungen vorgesehen sein, dass die Kappe zumindest eine, insbesondere integrierte, Linse aufweist. Ferner kann die Komponente zumindest einen optischen Detektor oder Emitter aufweisen. Es kann vorgesehen sein, dass zwischen der Linse und dem Detektor bzw. Emitter der abgedichtete Zwischenraum angeordnet ist. Typischerweise sind die Linse und der Detektor bzw. Emitter nach dem Anordnen von Kappe und Komponente übereinander angeordnet.

Es kann auch vorgesehen sein, dass das elektronische Bauelement ein MEMS-Bauelement ist. Hierbei kann die Kappe und/oder die Komponente einen Inertialsensor, einen Drucksensor, ein Mikrobolometer und/oder einen RF-Switch aufweisen. Es kann ferner vorgesehen sein, dass das Bauelement ein optisches MEMS-Bauelement ist, wobei die Komponente und/oder die Kappe Mikrospiegel oder Spiegel-Arrays aufweist. Das elektronische Bauelement kann beispielsweise ein hermetisches Package für empfindliche optoelektronische Bauelemente, beispielsweise Laserdioden oder Photodetektoren, bilden. Außerdem kann das elektronische Bauelement vorteilhafterweise eine Mikro-Batterie umfassen. Das elektronische Bauelement kann auch ein Mikrofluidik-Bauelement sein, das durch den abgedichteten Zwischenraum versiegelte und mit Wasser gefüllte Heat-Pipes oder Vapour-Chambers aufweist.

Oben oder unten in Bezug auf das Verfahren zur Herstellung des elektronischen Bauelements beschriebene Merkmale sind entsprechend auf das elektronische Bauelement anwendbar und umgekehrt.

Ausführungsbeispiele werden nachfolgend anhand der Abbildungen beschrieben. Es zeigen
Fign. 1(a) bis (d) schematische Ansichten zur Illustration eines Verfahrens zur Herstellung eines elektronischen Bauelements gemäss der Erfindung.
Fign. 2(a) bis (d) schematische Ansichten zur Illustration eines Verfahrens zur Herstellung eines elektronischen Bauelements gemäß einer weiteren Ausführungsform der Erfindung und
Fign. 3(a) bis (d) weitere schematische Ansichten zur Illustration eines Verfahrens zur Herstellung eines elektronischen Bauelements gemäss der Erfindung.

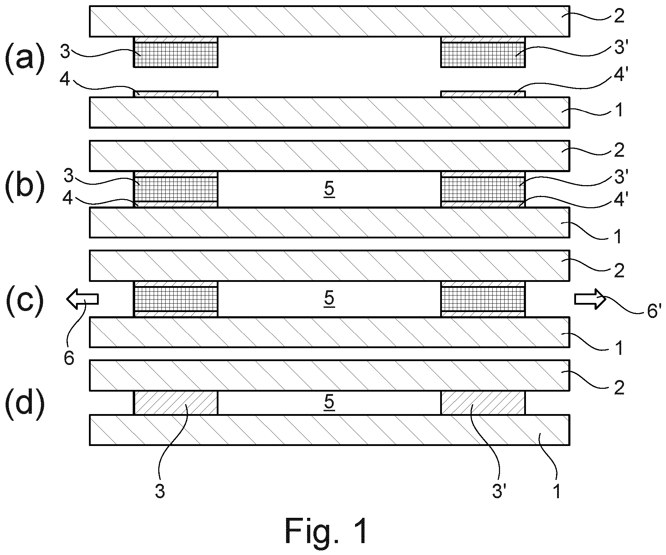

Figuren 1(a) bis 1(d) illustrieren Schritte eines Verfahrens zur Herstellung eines elektronischen Bauelements. Das Verfahren erlaubt das Herstellen eines gezielt mit einem Gas befüllten oder evakuierten Zwischenraums in dem elektronischen Bauelement. Bei dem vorgeschlagenen Verfahren kann zunächst eine Komponente 1, beispielsweise ein Halbleiterchip oder ein Halbleiterwafer mit integrierten Schaltkreisen, bereitgestellt werden. Außerdem kann eine Kappe 2 bereitgestellt werden, die beispielsweise als Wafer oder als Chip ausgeführt sein kann. Die Kappe umfasst auf einer Oberfläche einen geschlossenen Ring aus nanoporösem Gold, welches ein zunächst gasdurchlässiges Dichtelement 3 ausbildet, gekennzeichnet in dem in Fig. 1(a) dargestellten Querschnitt mit den Bezugszeichen 3 und 3'. In einer anderen Ausführung kann das Dichtelement 3 auch auf der Komponente 1 angeordnet sein. Die Kappe 2 kann mit einem an sich bekannten Flip-Chip-Bonder zu der Komponente ausgerichtet werden (Alignment) und mit dem Flip-Chip-Bonder in einem ersten Bondschritt auf die Komponente 2 gebondet werden. Hierfür wird die Kappe 2 so über der Komponente 1 angeordnet und ausgerichtet, dass das Dichtelement 3 einer auf einer Oberfläche der Komponente 1 abgeschiedenen ringförmigen Gegenfläche 4 zugewandt ist, die beispielsweise durch eine entsprechend dem Dichtelement 3 geformte Goldbeschichtung gebildet wird und in der Abbildung mit den Bezugszeichen 4 und 4' gekennzeichnet ist. Nach der Ausrichtung der Kappe 2 zur Komponente 1 wird die Kappe 2 durch den Flip-Chip-Bonder in einem Thermokompressionsbonding-Schritt bei erhöhter Temperatur an die Komponente angedrückt. Dieses erste Bonden findet beispielsweise an normaler Umgebung, insbesondere an Luft, statt.

Zur Herstellung des porösen Dichtelements 3 kann beispielsweise zunächst eine Silber-Gold-Legierung auf der Komponente 1 oder der Kappe 2 galvanisch abgeschieden werden. Anschließend kann das Silber der Legierung geätzt werden, sodass das zunächst gasdurchlässige Dichtelement 3 in Form eines schwammartigen, jedoch offenporigen und nanoporösen Golds verbleibt.

Durch das erste Bonden ergibt sich die in Fig. 1(b) gezeigte Anordnung, bei der das Dichtelement 3 stoffschlüssig mit der Gegenfläche 4 verbunden ist. Hierdurch sind die Komponente 1 und die Kappe 2 bereits mechanisch fest miteinander verbunden. Wiederkehrende Merkmale sind in dieser und in den folgenden Abbildungen mit den gleichen Bezugszeichen versehen. Das Dichtelement 3 bildet einen Ring aus, der einen Zwischenraum 5 zwischen der Komponente 1 und der Kappe 2 vollständig umlaufend begrenzt. Das Dichtelement 3 ist durch das erste Bonden in der Regel noch nicht verdichtet und Poren des Dichtelements 2 sind durch das erste Bonden nicht verschlossen, sodass das Dichtelement 3 nach dem ersten Bonden weiterhin offenporig und gasdurchlässig ist.

In einem zweiten Bondschritt in einem zweiten Bonder, der nicht dem als Flip-Chip-Bonder ausgeführten ersten Bonder entsprechen muss, soll das Dichtelement 3 zur Abdichtung des Zwischenraums 5 abgedichtet werden. Vor diesem Abdichten des Dichtelements 3 durch das zweite Bonden wird der Zwischenraum 5, in der Regel nach Entnahme des teilweise hergestellten Bauelementes aus dem Flip-Chip-Bonder, gezielt einer Gasatmosphäre oder einem Vakuum ausgesetzt, was die Fig. 1(c) illustriert. Die Pfeile mit den Bezugszeichen 6 und 6' illustrieren, dass Luft aus dem Zwischenraum ausströmt, indem eine Vakuumpumpe an eine Kammer, in der die Komponente 1 und die Kappe 2 angeordnet sind, angeschlossen werden. Diese Kammer bildet bereits einen Teil des zweiten Bonders, in dem der nachfolgende zweite Bondschritt durchgeführt wird. Dadurch, dass in der Kammer ein Vakuum herrscht, bildet sich auch ein Vakuum in dem Zwischenraum 5. Nachfolgend können die Komponente 1 und die Kappe 2 in der Kammer ausgeheizt werden, beispielsweise durch fahren eines Temperaturprofils, sodass sich der Druck in dem Zwischenraum 5 weiter verringert.

Das zweite Bonden kann ebenfalls in der Kammer des zweiten Bonders durchgeführt werden und ist wie das erste Bonden ein Thermokompressionsbonden, bei dem die Kappe 2 und die Komponente 1 bei erhöhter Temperatur zusammengepresst werden. Sowohl die Temperatur als auch der Druck sind bei diesem zweiten Bonden höher als bei dem vorherigen ersten Bonden. Im Allgemeinen ist in der Regel mindestens einer der beiden Bond-Parameter Druck oder Temperatur beim zweiten Bonden höher als beim ersten Bonden. Wie Fig. 1(d) illustriert verringert sich ein Abstand zwischen der Kappe 2 und der Komponente 1 beim zweiten Bonden durch eine Kompression des Dichtelements 3. Hierbei werden die Poren des Dichtelements 3 so verschlossen, dass das Dichtelement 3 den Zwischenraum 5 gasdicht abschließt und versiegelt. Somit wird erreicht, dass das Vakuum im Zwischenraum 5 auch dann noch verbleibt, wenn die Komponente 1 gemeinsam mit der Kappe 2 aus der Kammer des zweiten Bonders entnommen wurde und das fertig hergestellte elektronische Bauelement bildet.

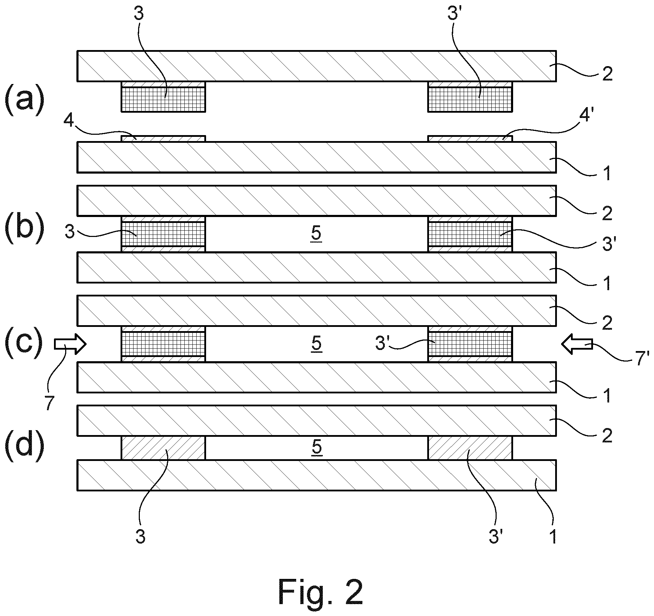

Das Herstellungsverfahren, das in Fign. 2(a) bis (d) illustriert ist, entspricht dem oben in Bezug auf Fign. 1(a) bis (d) beschriebenen Verfahren mit dem Unterschied, dass in dem Zwischenraum 5 nach dem zweiten Bonden kein Vakuum herrscht. Stattdessen wird vor dem zweiten Bonden in der Kammer des zweiten Bonders gezielt eine Gasatmosphäre erzeugt. Hierbei kann es sich beispielsweise um ein inertes Gas, beispielsweise Stickstoff, oder ein Edelgas wie Helium, Argon oder Krypton handeln. Typischerweise ist die Gasatmosphäre keine gewöhnliche Raumluftatmosphäre. Wie die Pfeile mit den Bezugszeichen 7 und 7' in Fig. 2(c) illustrieren strömt das gasförmige Medium durch das offenporige Material des Dichtelements 3 in den Zwischenraum 5. Anschließend wird das Dichtelement 3 beim zweiten Bonden wie oben beschrieben komprimiert, sodass der Zwischenraum 5 abgedichtet wird. Das Gas verbleibt daher auch nach Fertigstellung des elektronischen Bauelements in dem Zwischenraum 5. Bei dem Gas kann es sich beispielsweise um ein Inertgas, z.B. für Inertialsensoren zur Einstellung der Dämpfung, handeln. Es kommen aber auch weitere in dieser Anmeldung beschriebene Anwendungsfälle in Betracht. Eine Grundfläche des abgedichteten Zwischenraums 5, der je nach Ausführungsform mit Fluid, insbesondere mit dem Gas, befüllt ist oder in dem ein Vakuum herrscht beträgt in realistischen Ausführungen zumindest 10 µm², insbesondere zumindest 0,2 mm², und/oder höchstens 100 cm², insbesondere höchstens 500 mm². Kleinere Flächen können beispielsweise wenige µm Kantenlänge aufweisen, z.B. 5 µm x 5 µm, größere hingegen Abmessungen bis zu 100 mm x 100 mm. Typische Werte liegen bei 1 mm x 1 mm bis 15 mm x 15 mm.

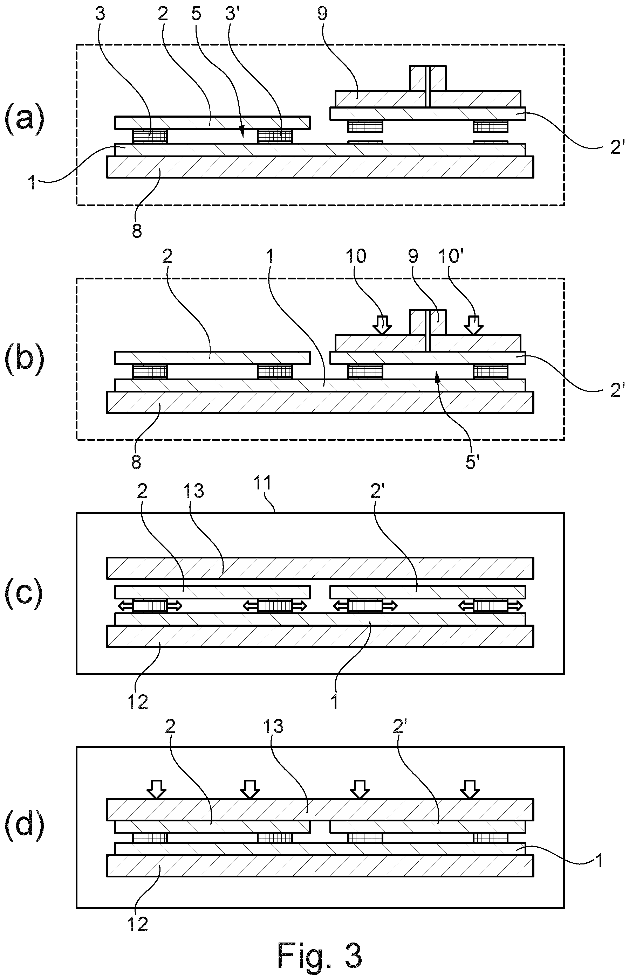

Figuren 3(a) bis (d) illustrieren weitere Schritte zur Herstellung des elektronischen Bauelements. Bei diesem Verfahren werden mehrere Kappen 2, 2' mit dem Flip-Chip-Bonder sequentiell zu der Komponente 1 ausgerichtet und auf diese aufgebracht. Beispielsweise ist ein sequentielles hermetisches Bonden von vielen Einzelkappen auf einer als Funktionswafer ausgeführten Komponente 1 vorgesehen. Hierbei kann der erste Bonder ein Bonder sein, der an Luft oder ggf. unter einem Inertgas-Vorhang arbeitet. Bei diesem Chip-zu-Wafer-Bonden werden die Kappen von einem Vorlageplatz aufgenommen und an der jeweiligen Position auf dem Wafer angeordnet und gebondet. Die Kappen 2, 2' sind wie die oben beschriebene Kappe 2 ausgeführt. In dem in Fig. 3(a) illustrierten Zustand liegt die Komponente 1 auf einem Tisch 8 des Flip-Chip-Bonders und die linke Kappe 2 ist bereits wie oben im Detail beschrieben durch den ersten Bondschritt an die Komponente 1 gebondet. Die rechte Kappe 2' ist wie die linke Kappe 2 ausgeführt und wird gerade von einem Manipulator 9 des Flip-Chip-Bonders gehalten und zur Komponente 1 ausgerichtet. Dieser Prozess findet an Luft statt. Figur 3(b) zeigt das erste Bonden der rechten Kappe 2', bei dem der Flip-Chip-Bonder die zweite Kappe 2' bei erhöhter Temperatur an die Komponente 1 andrückt, wie die Pfeile mit Bezugszeichen 10 und 10' illustrieren. Anschließend können in entsprechender Weise sequentiell weitere nicht dargestellte Kappen auf die Komponente 1 gebondet werden bis alle Positionen auf der Komponente 1 bestückt sind.

Anschließend wird die Komponente 1 mit den daran durch das erste Bonden haltbar befestigten Kappen 2, 2' in eine in Fign. 3(c) und 3(d) gezeigte Kammer 11 eines zweiten Bonders überführt. Im zweiten Bonder ist kein Alignment mehr notwendig, da die Kappen 2, 2' bereits zuvor im ersten Bonder bei normaler Umgebungsluft einzeln fixiert wurden. Der Wafer bzw. die Komponente 1 kann in einem weiteren Schritt in der Kammer 11 weiter behandelt werden durch Tempern bzw. Ausheizen im Vakuum. In der Kammer 11 herrscht anschließend, je nachdem, welcher Füllzustand der Zwischenräume 5, 5' des fertig hergestellten elektronischen Bauelements gewünscht wird, eine gezielt durch Vakuumpumpe oder Gasquellen des zweiten Bonders in die Kammer 11 eingebrachte Gas- oder eine Vakuumatmosphäre. In der Kammer 11 wird die Komponente 1 auf einem Tisch 12 des zweiten Bonders angeordnet. Anschließend wird durch einen oberen Teil 13 des zweiten Bonders ein Anpressdruck gleichzeitig auf alle Kappen 2, 2' in Richtung der Komponente 1 bei erhöhter Temperatur ausgeübt, so dass die Dichtelemente 4, 4' der unterschiedlichen Kappen zur Abdichtung der Zwischenräume 5, 5' verdichtet werden. Eventuelle Höhendifferenzen können mit einer weichen, temperaturbeständigen Folie auf Oberseiten der Kappen 2, 2' ausgeglichen und so der Druck auf alle Kappen 2, 2' gleichmäßiger verteilt.

Es kann in anderen Ausführungen vorgesehen sein, dass der zweiten Kompressionsschritt zum Verschließen der Kappen in einem Stapel mit mehreren Wafern durchgeführt wird. Hierbei können die Stapel von übereinander angeordneten Wafern mit den jeweiligen vorgebondeten Kappen jeweils durch eine Folie separiert werden, welches bei geringen Höhenunterschieden den Druck ausgleichen kann. Somit können in der Kammer 11 des zweiten Bondens das Ausheizen, die Vakuumprozesse oder die Gasbefüllung und auch das Verschließen in einer integrierten Presse für alle Wafer gleichzeitig erfolgen.

Lediglich in den Ausführungsbeispielen offenbarte Merkmale der verschiedenen Ausführungsformen können miteinander kombiniert und einzeln beansprucht werden.

## Patentansprüche

1. Verfahren zur Herstellung eines elektronischen Bauelements, folgende Schritte umfassend:
- Bereitstellen einer flächigen Komponente (1),
- Bereitstellen einer Kappe (2),
- Anordnen eines porösen und fluiddurchlässigen, insbesondere gasdurchlässigen, Dichtelements (3) auf der Kappe (2) oder auf der Komponente (1), umfassend
- eine Herstellung des porösen und fluiddurchlässigen Dichtelements (3) durch Anordnen einer Legierung, die eine erste Legierungskomponente und eine zweite Legierungskomponente enthält, auf der Kappe (2) oder auf der Komponente (1) und
- nachfolgendes Ätzen der zweiten Legierungskomponente, derart dass die erste Legierungskomponente verbleibt und dadurch das poröse und fluiddurchlässige Dichtelement (3) ausbildet;
- Anordnen der Komponente (1) und der Kappe (2) so zueinander, dass das Dichtelement (3) zwischen der Kappe (2) und der Komponente (1) angeordnet ist und sowohl mit der Kappe (2) als auch der Komponente (1) in Kontakt steht und dass ein Zwischenraum (5) zwischen der Kappe (2) und der Komponente (1) zumindest abschnittsweise durch das poröse und fluiddurchlässige Dichtelement (3) begrenzt wird,
- Erstes Bonden der Komponente (1) und der Kappe (2) durch Anwenden eines ersten Bonddrucks und/oder einer ersten Bondtemperatur derart, dass eine mechanisch haltbare Verbindung zwischen der Komponente (1) und der Kappe (2) erzeugt wird,
- Aussetzen der Kappe (2) und der Komponente (1) einem Fluid, insbesondere einer Gasatmosphäre, oder einem Vakuum, nach dem ersten Bonden, wobei Fluid bzw. Gas durch Poren des Dichtelements (3) in den Zwischenraum (5) strömt oder aus diesem entweicht,
- Zweites Bonden der Komponente (1) und der Kappe (2) durch Anwenden eines zweiten Bonddrucks und/oder einer zweiten Bondtemperatur, wodurch die Poren des Dichtelements (3) verschlossen werden und der Zwischenraum (5) abgedichtet wird.

2. Verfahren nach Anspruch 1, **dadurch gekennzeichnet, dass** das Dichtelement (3) sowohl die mechanisch haltbare Verbindung zwischen der Komponente (1) und der Kappe (2) sicherstellt als auch eine Abdichtung des Zwischenraums (5) gewährleistet.

3. Verfahren nach einem der Ansprüche 1 oder 2, **dadurch gekennzeichnet, dass** das Dichtelement (3) den Zwischenraum (5) vollständig geschlossen umläuft.

4. Verfahren nach einem der Ansprüche 1 bis 3, **dadurch gekennzeichnet, dass** das poröse und fluiddurchlässige Dichtelement (3) ein poröses Metall, insbesondere poröses Gold, enthält.

5. Verfahren nach einem der Ansprüche 1 bis 4, **dadurch gekennzeichnet, dass** das poröse und fluiddurchlässige Dichtelement (3) nanoporös ist.

6. Verfahren nach einem der Ansprüche 1 bis 5, **dadurch gekennzeichnet dass** die Kappe (2) oder die Komponente (1) eine Gegenfläche (4) aufweist, die vor dem ersten Bonden auf der Komponente (1) oder auf der Kappe (2) so dem Dichtelement (3) gegenüber angeordnet und ausgebildet ist, dass durch das erste Bonden eine stoffschlüssige Verbindung zwischen dem Dichtelement (3) und der Gegenfläche (4) ausgebildet wird.

7. Verfahren nach einem der Ansprüche 1 bis 6, **dadurch gekennzeichnet, dass** der erste Bonddruck und/oder die erste Bondtemperatur niedriger ist als der zweite Bonddruck bzw. die zweite Bondtemperatur.

8. Verfahren nach einem der Ansprüche 1 bis 7, **dadurch gekennzeichnet, dass** das erste Bonden durch einen Flip-Chip-Bonder erfolgt.

9. Verfahren nach einem der Ansprüche 1 bis 8, **gekennzeichnet durch**:
- Bonden einer weiteren Kappe (2') auf die Komponente (1) nach dem ersten Bonden der Komponente (1) und der Kappe (2), wobei ein weiteres poröses und fluiddurchlässiges, insbesondere gasdurchlässiges, Dichtelement einen weiteren Zwischenraum (5'), der zwischen der weiteren Kappe (2') und der Komponente (1) ausgebildet ist, begrenzt.

10. Verfahren nach Anspruch 9, **dadurch gekennzeichnet, dass** beim zweiten Bonden gleichzeitig mit der Kappe (2) auch die weitere Kappe (2') mit der Komponente (1) gebondet wird, wodurch Poren des weiteren Dichtelements verschlossen und der weitere Zwischenraum (5') abgedichtet wird.

11. Verfahren nach einem der Ansprüche 1 bis 10, **gekennzeichnet durch**:
- Anordnen eines zweiten porösen und fluiddurchlässigen, insbesondere gasdurchlässigen, Dichtelements auf einer zweiten Kappe oder auf einer zweiten Komponente,
- Anordnen der zweiten Komponente und der zweiten Kappe so zueinander, dass das zweite Dichtelement zwischen der zweiten Kappe und der zweiten Komponente angeordnet ist und sowohl mit der zweiten Kappe als auch der zweiten Komponente in Kontakt steht und dass ein zweiter Zwischenraum zwischen der zweiten Kappe und der zweiten Komponente zumindest abschnittsweise durch das zweite poröse und fluiddurchlässige Dichtelement begrenzt wird,
- Bonden der zweiten Komponente und der zweiten Kappe durch Anwenden eines Bonddrucks und/oder einer Bondtemperatur derart, dass eine mechanisch haltbare Verbindung zwischen der zweiten Komponente und der zweiten Kappe erzeugt wird,
- Aussetzten der zweiten Kappe und der zweiten Komponente dem Fluid, insbesondere der Gasatmosphäre, oder dem Vakuum gemeinsam mit der Kappe und der Komponente derart, dass Fluid, insbesondere Gas, durch Poren des zweiten Dichtelements in den zweiten Zwischenraum strömt oder aus diesem entweicht und derart, dass die zweite Kappe und die zweite Komponente auf der Kappe (2) und der Komponente (1) angeordnet sind,
wobei beim zweiten Bonden der Komponente (1) und der Kappe (2) gleichzeitig die darüber liegende zweite Komponente und zweite Kappe durch Anwenden des zweiten Bonddrucks und/oder der zweiten Bondtemperatur gebondet werden, wodurch die Poren des zweiten Dichtelements verschlossen werden und der zweite Zwischenraum abgedichtet wird.

## Claims

1. A method to manufacture an electronic component, comprising the following steps:
- providing a planar component (1),
- providing a cap (2),
- arranging a porous and fluid-permeable, particularly gas-permeable, sealing element (3) on the cap (2) or on the component (1), comprising
- the manufacture of the porous and fluid-permeable sealing element (3) by arranging an alloy containing a first alloy component and a second alloy component on the cap (2) or on the component (1), and
- a subsequent etching of the second alloy component, such that the first alloy component remains and thereby forms the porous and fluid-permeable sealing element (3);
- arranging the component (1) and the cap (2) in relation to one another such that the sealing element (3) is arranged between the cap (2) and the component (1) and is in contact with both the cap (2) and the component (1), and that an intermediate space (5) between the cap (2) and the component (1) is bounded at least sectionally by the porous and fluid-permeable sealing element (3),
- first bonding of the component (1) and the cap (2) by applying a first bonding pressure and/or a first bonding temperature in such a way to create a mechanically durable connection between the component (1) and the cap (2),
- exposing the cap (2) and the component (1) to a fluid, particularly a gas atmosphere, or to a vacuum, after the first bonding, with fluid or gas flowing through pores in the sealing element (3) into the intermediate space (5) or escaping from it,
- second bonding of the component (1) and the cap (2) by applying a second bonding pressure and/or a second bonding temperature, thereby closing the pores of the sealing element (3) and sealing the intermediate space (5).

2. The method according to claim 1, **characterized in that** the sealing element (3) both ensures the mechanical durability of the connection between the component (1) and the cap (2) is as well as a sealing of the intermediate space (5).

3. A the method according to one of claims 1 or 2, **characterized in that** the sealing element (3) completely surrounds the intermediate space (5).

4. The method according to any of claims 1 to 3, **characterised in that** the porous and fluid-permeable sealing element (3) contains a porous metal, in particular porous gold.

5. The method according to any of claims 1 to 4, **characterised in that** the porous and fluid-permeable sealing element (3) is nanoporous.

6. The method according to one of claims 1 to 5, **characterized in that** the cap (2) or the component (1) has a counter-surface (4) which, prior to the first bonding, is arranged on the component (1) or on the cap (2) opposite the sealing element (3) and is designed in such a way that the first bonding forms a materially bonded connection between the sealing element (3) and the counter-surface (4).

7. The method according to any of claims 1 to 6, **characterised in that** the first bonding pressure and/or the first bonding temperature is/are lower than the second bonding pressure and/or the second bonding temperature.

8. The method according to any of claims 1 to 7, **characterised in that** the first bonding occurs via a flip-chip bonder.

9. The method according to any one of claims 1 to 8, **characterized by**: - bonding a further cap (2') onto the component (1) after the first bonding of the component (1) and the cap (2), whereby a further porous and fluid-permeable, particularly gas-permeable, sealing element delimits a further intermediate space (5') formed between the further cap (2') and the component (1).

10. The method according to claim 9, **characterized in that** during the second bonding the further cap (2') is simultaneously bonded to the component (1) together with the cap (2), whereby closing pores of the further sealing element and sealing the further intermediate space (5').

11. The method according to any one of claims 1 to 10, **characterized by**:
- arranging a second porous and fluid-permeable, in particular gas-permeable, sealing element on a second cap or on a second component,
- arranging the second component and the second cap in relation to one another such that the second sealing element is arranged between the second cap and the second component and is in contact with both the second cap and the second component, and such that a second intermediate space between the second cap and the second component is at least partially bounded by the second porous and fluid-permeable sealing element,
- bonding the second component and the second cap by applying a bonding pressure and/or a bonding temperature in such a way to create a mechanically durable connection between the second component and the second cap,
- exposing the second cap and the second component to the fluid, particularly the gas atmosphere, or to the vacuum together with the cap and the component in such a way that fluid, in particular gas, flows through pores of the second sealing element into the second intermediate space or escapes from it and in such a way that the second cap and the second component are arranged on the cap (2) and the component (1),
whereby during the second bonding of the component (1) and the cap (2), the second component and overlying second cap are simultaneously bonded by applying the second bonding pressure and/or the second bonding temperature, whereby the pores of the second sealing element are closed and the second intermediate space is sealed.

## Revendications

1. Procédé de fabrication d'un composant électronique, comprenant les étapes ci-dessous consistant à :
- fournir un composant (1) plan,
- fournir un capuchon (2),
- agencer un élément d'étanchéité (3) poreux et perméable aux fluides, en particulier perméable aux gaz, sur le capuchon (2) ou sur le composant (1), ce qui comprend
- une fabrication de l'élément d'étanchéité poreux et perméable aux fluides (3) grâce à l'agencement d'un alliage, contenant un premier composant d'alliage et un second composant d'alliage, sur le capuchon (2) ou sur le composant (1), et
- corroder ensuite le second composant d'alliage de telle manière que le premier composant d'alliage demeure et forme ainsi l'élément d'étanchéité poreux et perméable aux fluides (3) ;
- agencer le composant (1) et le capuchon (2) l'un par rapport à l'autre de sorte que l'élément d'étanchéité (3) est agencé entre le capuchon (2) et le composant (1) et est en contact à la fois avec le capuchon (2) et avec le composant (1) et de sorte qu'un espace intermédiaire (5) entre le capuchon (2) et le composant (1) est au moins localement délimité par l'élément d'étanchéité poreux et perméable aux fluides (3),
- coller en premier lieu le composant (1) et le capuchon (2) grâce à l'application d'une première pression de collage et/ou d'une première température de collage de telle manière qu'une liaison mécaniquement durable est créée entre le composant (1) et le capuchon (2),
- exposer le capuchon (2) et le composant (1) à un fluide, en particulier à une atmosphère gazeuse, ou à un vide, après le premier collage, dans lequel le fluide ou le gaz s'écoule dans l'espace intermédiaire (5), ou s'en échappe, à travers des pores de l'élément d'étanchéité (3),
- coller en second lieu le composant (1) et le capuchon (2) grâce à l'application d'une seconde pression de collage et/ou d'une seconde température de collage, ce qui permet d'obturer les pores de l'élément d'étanchéité (3) et de rendre étanche l'espace intermédiaire (5).

2. Procédé selon la revendication 1, **caractérisé en ce que** l'élément d'étanchéité (3) assure à la fois la liaison mécaniquement durable entre le composant (1) et le capuchon (2) et l'étanchéité de l'espace intermédiaire (5).

3. Procédé selon l'une quelconque des revendications 1 à 2, **caractérisé en ce que** l'élément d'étanchéité (3) entoure l'espace intermédiaire (5) de manière complètement fermée.

4. Procédé selon l'une quelconque des revendications 1 à 3, **caractérisé en ce que** l'élément d'étanchéité (3) poreux et perméable aux fluides contient un métal poreux, en particulier de l'or poreux.

5. Procédé selon l'une quelconque des revendications 1 à 4, **caractérisé en ce que** l'élément d'étanchéité (3) poreux et perméable aux fluides est nanoporeux.

6. Procédé selon l'une quelconque des revendications 1 à 5, **caractérisé en ce que** le capuchon (2) ou le composant (1) présente une contre-surface (4) qui, est agencée par rapport à l'élément d'étanchéité (3) avant le premier collage sur le composant (1) ou sur le capuchon (2) et est conçue de sorte qu'une liaison par complémentarité de matière entre l'élément d'étanchéité (3) et la contre-surface (4) est créée grâce au premier collage.

7. Procédé selon l'une quelconque des revendications 1 à 6, **caractérisé en ce que** la première pression de collage et/ou la première température de collage est inférieure à la seconde pression de collage ou à la seconde température de collage.

8. Procédé selon l'une quelconque des revendications 1 à 7, **caractérisé en ce que** le premier collage intervient grâce à un appareil de collage de puce retournée.

9. Procédé selon l'une quelconque des revendications 1 à 8, **caractérisé par** l'étape consistant à : - coller un capuchon (2') supplémentaire sur le composant (1) après le premier collage du composant (1) et du capuchon (2), dans lequel un élément d'étanchéité supplémentaire poreux et perméable aux fluides, en particulier perméable aux gaz, délimite un espace intermédiaire (5') supplémentaire qui est formé entre le capuchon (2') supplémentaire et le composant (1).

10. Procédé selon la revendication 9, **caractérisé en ce que**, lors du second collage, le capuchon (2') supplémentaire est également collé au composant (1) en même temps que le capuchon (2), ce qui permet d'obturer les pores de l'élément d'étanchéité supplémentaire et de rendre étanche l'espace intermédiaire (5') supplémentaire.

11. Procédé selon l'une quelconque des revendications 1 à 10, **caractérisé par** les étapes consistant à :
- agencer un second élément d'étanchéité poreux et perméable aux fluides, en particulier perméable aux gaz, sur un second capuchon ou sur un second composant,
- agencer le second composant et le second capuchon l'un par rapport à l'autre de sorte que le second élément d'étanchéité est agencé entre le second capuchon et le second composant et est en contact à la fois avec le second capuchon et avec le second composant et de sorte qu'un second espace intermédiaire entre le second capuchon et le second composant est au moins partiellement délimité par le second élément d'étanchéité poreux et perméable aux fluides,
- coller le second composant et le second capuchon grâce à l'application d'une pression de collage et/ou d'une température de collage de telle manière qu'une liaison mécaniquement durable est créée entre le second composant et le second capuchon,
- exposer le second capuchon et le second composant au fluide, en particulier à l'atmosphère gazeuse, ou au vide conjointement au capuchon et au composant de telle manière que le fluide, en particulier le gaz, s'écoule dans le second espace intermédiaire, ou s'en échappe, à travers des pores du second élément d'étanchéité, et de telle manière que le second capuchon et le second composant sont agencés sur le capuchon (2) et le composant (1),
dans lequel, lors du second collage du composant (1) et du capuchon (2), le second composant et le second capuchon situés au-dessus de ceux-ci sont simultanément collés grâce à l'application de la seconde pression de collage et/ou de la seconde température de collage, ce qui permet d'obturer les pores du second élément d'étanchéité et de rendre étanche le second espace intermédiaire.
